# EUROPÄISCHE PATENTSCHRIFT

(11) **EP 2 573 831 B1**
(45) Veröffentlichungstag und Bekanntmachung des Hinweises auf die Patenterteilung: **16.12.2015**
(21) Anmeldenummer: 12006649.3
(22) Anmeldetag: 21.09.2012
(51) Int. Cl.: H01L 35/30, H01L 35/32, F25B 21/02, B60H 1/00, F28F 9/16, F28D 7/00, F28F 1/02, F28F 1/04

(54) **Segmentiertes Flachrohr einer thermoelektrischen Wärmepumpe und thermoelektrische Wärmeübertragereinheit**
Segmented flat tube of a thermoelectric heat pump and thermoelectric heat transfer unit
Tuyau plat segmenté d'une pompe à chaleur thermoélectrique et unité caloporteuse thermoélectrique

(30) Priorität: 21.09.2011 DE 102011113978
(43) Veröffentlichungstag der Anmeldung: 27.03.2013
(73) Patentinhaber: Volkswagen Aktiengesellschaft, 38440 Wolfsburg (DE)
(72) Erfinder: Köhler, Jürgen, Prof. Dr.-Ing., 38173 Sickte (DE); Böttcher, Christof, Dr., 38442 Wolfsburg (DE); Beermann, Jürgen, 31535 Neustadt (DE); Junior, Christine Susanne, Dr., 38100 Braunschweig (DE); Dilger, Klaus, Prof. Dr.-Ing., 38106 Braunschweig (DE)

(56) Entgegenhaltungen:
- DE-A1-102009 058 674
- US-A- 4 065 936
- US-A1- 2009 025 770
- US-A1- 2011 067 742

## Beschreibung

Die Erfindung betrifft ein Flachrohr sowie eine thermoelektrische Wärmeübertragereinheit jeweils nach den Oberbegriffen der unabhängigen Patentansprüche.

Im Zuge der Verbreitung von elektrisch angetriebenen Fahrzeugen werden entsprechend angepasste Heiz- und Klimatisierungssysteme benötigt, die anders als bei konventionellen Fahrzeugen ohne die Abwärme eines Verbrennungsmotors und ohne mechanische Antriebsleistungserbringung auskommen. Aufgrund des begrenzten Energieinhalts der zur Versorgung derartiger Heiz- und Klimatisierungssysteme erforderlichen elektrischen Energiespeicher ist deren hohe Effizienz bei allen Betriebsbedingungen gefordert, um die Reichweite der Fahrzeuge nicht empfindlich einzuschränken. Zum Heizen und Kühlen des Innenraums derartiger Fahrzeuge bieten sich thermoelektrische Wärmepumpen an.

Wärmepumpen zum Übertragen eines Wärmestroms entgegen einem Temperaturgefälle mit Hilfe von thermoelektrischen Vorrichtungen sind bekannt. Bei den thermoelektrischen Vorrichtungen kann es sich um Peltier-Elemente handeln, die unter Zuführung von elektrischer Energie eine Wärmemenge von einer Kaltseite auf eine Warmseite des Peltier-Elements transportieren. Grundbaustein eines Peltier-Elements ist dabei ein sogenanntes Schenkelpaar, das aus zwei Schenkeln aus unterschiedlichen Halbleitermaterialen besteht - einem p-Leiter und einem n-Leiter. Die Halbleitermaterialien sind über eine Lötverbindung mit Leiterbahnen, den sogenannten Shunts, üblicherweise aus einem Kupfermaterial, miteinander verbunden.

Aufgrund der Ausbildung einer Warmseite und einer Kaltseite des Peltier-Elements kommt es zu einer Ausdehnung bzw. einem Zusammenziehen der Shunts auf der warmen Seite bzw. kalten Seite. Es treten dadurch an dem Peltier-Element Schubspannungen auf, die zum Abscheren der Lötverbindungen zwischen Halbmaterial und Shunt führen können. Es ist bekannt, solche Peltier-Elemente zwischen zwei Fluidströme zu schalten, um einem dieser Fluidströme einen Wärmestrom zu entziehen und diesen zuzüglich einer elektrischen Leistung an einen weiteren Fluidstrom abzugeben. Bei den Fluidströmen kann es sich um Ströme eines flüssigen und/oder gasförmigen Mediums handeln. Um die Wärmeübertragung zwischen Halbleitermaterial und Fluidseite zu verbessern, kann das thermoelektrische Material direkt an einen Wärmeübertrager angebunden sein, wie beispielsweise aus der WO 2008/013946 A2 bekannt ist. Beispielsweise kann zum Übertragen eines Wärmestroms zwischen einem ersten und zweiten Fluidstrom der erste bzw. zweite Fluidstrom vorteilhaft in einem ersten bzw. zweiten Flachrohr geführt werden, wobei zwischen den Flachrohren sandwichartig thermoelektrische Komponenten angeordnet sind, die derartig bestrombar sind, dass sich eine Warmseite und eine Kaltseite ausbildet. Dabei kann, wie aus der WO 99/04439 A1 bekannt ist, als Wärmeleiter zwischen dem thermoelektrischen Material und der Fluidseite ein wärmeleitendes Dielektrikum eingesetzt werden, wie beispielsweise Aluminiumnitrid.

Aus der DE 10 2010 005177 A1 ist bereits ein thermoelektrisches Modul bekannt mit zwei oder mehr Elementen aus n-dotierten und p-dotierten Halbmaterialien, die elektrisch in Reihe und thermisch parallel geschaltet sind.

Aus der DE 60 2004 000 980 T2 ist ferner ein thermoelektrisches Modul mit einem Paar Keramikplatten bekannt, wobei eine Mehrzahl von Halbleiterelementen vom N-Typ und P-Typ über eine obere und einer untere Kupferplatte elektrisch miteinander verbunden werden.

Wie aus der EP 1 932 695 A1 bekannt ist, können Peltier-Elemente nebeneinander oder aufeinander und in unterschiedlichen elektrischen Schaltungen eingesetzt werden, wobei sie vorteilhaft zwischen zwei Wärmetauschern in einer Sandwichstruktur angeordnet sind. Auch 3-Schicht-Sandwichstrukturen sind dabei möglich, wobei in diesen Fällen beide Flächen eines Wärmetauschers der kalten Seite an der kalten Seite der Peltier-Elemente und die Wärmeübertragung von der warmen Seite durch zwei andere Wärmetauscher auf der warmen Seite erfolgt, wobei die warmen Seiten der Peltier-Elemente an einen Wärmetauscher der warmen Seite grenzen.

Eine thermoelektrische Generatoreinheit mit zumindest einem thermisch-elektrischen Modul, welches in einer sandwichartigen Anordnung an einer Seite einen Abgaswärmetauscher und an der gegenüberliegenden Seite einen Kühlmitteltauscher aufweist, ist in der WO 2010/112571 A2 beschrieben. Der Abgas- und der Kühlmitteltauscher sind dabei als Flachrohre ausgeführt, deren Flachseiten jeweils über seitliche Wandabschnitte verbunden sind. An den seitlichen Randabschnitten der beiden aussenliegenden Wärmetauscher sind Seitenwände befestigt, die die Spannkräfte für eine gleichmäßige, dauerhafte Verpressung der einzelnen Elemente der thermoelektrischen Generatoreinheit aufnehmen sollen.

US Patentschrift US 4065936 betrifft ein Flachrohr sowie eine thermoelektrische Wärmeübertragereinheit jeweils nach den Oberbegriffen der unabhängigen Patentansprüche.

Im Betrieb der oben erwähnten Anordnungen und Vorrichtungen können aufgrund der beschriebenen Scherkräfte thermomechanische Belastungen auftreten, welche die mechanische Integrität beeinträchtigen können.

Aufgabe der Erfindung ist es daher, die verbesserte Übertragung eines Wärmestroms von einem Flachrohr einer thermoelektrischen Wärmepumpe zu ermöglichen, wobei die im Betrieb auftretenden Schubspannungen abgebaut werden sollen.

Die Aufgabe wird mit den Merkmalen der unabhängigen Patentansprüche gelöst. Weitere Ausführungsformen sind in den abhängigen Patentansprüchen zu finden.

Das erfindungdungsgemäße Flachrohr einer thermoelektrischen Wärmepumpe ist über eine Vielzahl von auf seiner Ober- und/oder Unterseite angeordneten ersten Shunts gekennzeichnet, welche eine mit einer Vielzahl von thermoelektrischen Pellets thermisch und elektrisch miteinander verbinden, wobei die thermoelektrischen Pellets auf der gegenüberliegenden Seite mit einer Vielzahl von zweiten Shunts thermisch und elektrisch verbunden sind und zeichnet sich aus dadurch aus, dass das Flachrohr aus zumindest einem ersten und einem zweiten Teilsegment besteht, welche an ihrer Schnittstelle mittels zumindest eines Weichelementes zur Kompensation auftretender thermischer Spannungen fluidmäßig verbunden sind.

Erfindungsgemäß sind die Vielzahl von ersten Shunts und die Vielzahl von zweiten Shunts derartig angeordnet, dass die thermoelektrischen Pellets elektrisch in Reihe geschaltet oder schaltbar sind, womit trotz der Segmentierung eine einfache elektrische Verschaltung der Pellets erreicht werden kann.

Als Weichelement wird in diesem Zusammenhang ein Element aus einem Material mit einer geringeren Steifigkeit und/oder höheren Elastizität im Vergleich zu dem Material, aus dem die Flachrohre gefertigt sind, bezeichnet. Die Flachrohre sind üblicherweise aus Aluminium oder einem anderen Metall mit ausreichender Steifigkeit gefertigt, um eine ausreichende mechanische Stabilität zu gewährleisten. Als Material für das Weichelement kommen vorzugsweise Elastomere (Kautschuk, Gummi) oder thermoplastische Elastomere wie TPE-U1, TPE-U2, TPE-V oder TPE-A zum Einsatz. Als Schnittstelle zwischen zwei Tellsegmenten wird der Bereich bezeichnet, in dem korrespondierende Endbereiche zweier Flachrohrelemente liegen. Im einfachsten Fall handelt es sich um gerade Schnittflächen, welche die Stirnflächen der Flachrohrelemente bilden. Es versteht sich, dass auch kompliziertere Schnittstellen von der Erfindung umfasst werden. Vorzugsweise ist das Weichelement dabei so dimensioniert, dass der Strömungsquerschnitt im Bereich zwischen den beiden Flachrohrelementen gegenüber dem Strömungsquerschnitt der Flachrohrelemente nicht verändert ist, um eine Erhöhung des Strömungswiderstands des In den Flachrohren geführten Fluids zu vermeiden. Es versteht sich, dass die Weichelemente aus einem gegenüber den verwendeten Fluiden stabilen Material gefertigt sind und ferner in den in Frage kommenden Temperaturbereichen eine mindestens ausreichende Temperaturbeständigkeit aufweisen.

Durch den Einsatz von Weichelementen können die thermomechanischen Belastungen reduziert werden, da die im Betrieb auftretenden Schubspannungen von dem relativ weichen Material des Welchelements aufgenommen werden. Es können durch die Aneinanderreihung mehrerer Teilsegmente praktisch beliebig lange Flachrohre eingesetzt und damit vorteilhaft skalierte thermoelektrische Wärmeübertrager hergestellt werden.

Die Weichelemente werden vorzugsweise mit den Endbereichen der Flachrohre durch Anschmelzen, Aufvulkanisieren oder Kleben verbunden.

Eine weitere Ausführungsform zeichnet sich dadurch aus, dass zumindest eines der Teilsegmente auf seiner Ober- und/oder Unterseite eine wärmeleitende Isolationsschicht aufweist, auf der die Vielzahl der ersten Shunts angebracht sind, womit auf einfache Weise ein elektrischer Kurzschluß der Pellets verhindert wird.

Eine weitere Ausführungsform zeichnet sich dadurch aus, dass die Vielzahl von ersten Shunts und/oder die Vielzahl von zweiten Shunts thermisch und elektrisch mittels einer Lotverbindung mit den thermoelektrischen Pellets verbunden sind, womit auf einfache Weise Shunts und Pellets verbunden werden können.

Eine weitere Ausführungsform zeichnet sich dadurch aus, dass die Vielzahl von ersten Shunts und/oder die Vielzahl von zweiten Shunts thermisch und elektrisch mittels einer Klebeverbindung mit den thermoelektrischen Pellets verbunden sind, womit eine alternative Verbindung von Shunts und Pellets möglich ist.

Eine weitere Ausführungsform zeichnet sich dadurch aus, dass das Weichelement lippenartig ausgebildet und an einer ersten Stirnfläche eines ersten Flachrohrelements und an einer zweiten Stirnfläche eines zweiten Flachrohrelements angeordnet ist, wobei die Flachrohrelemente die Teilsegmente des Flachrohrs bilden, womit auf einfache Weise die gewünschte Hart/Weich-Verbindung realisiert werden kann.

Eine weitere Ausführungsform zeichnet sich dadurch aus, dass zweckmäßigerweise das Weichelement aus einem Elastomermaterial oder einem thermoplastischen Elastomermaterial besteht.

Die erfindungsgemäße thermoelektrische Wärmeübertragereinheit zum Übertragen eines Wärmestroms zwischen einem ersten und zweiten Fluidstrom mit einem ersten Flachrohr zum Führen des ersten Fluidstroms und einem zweiten Flachrohr zum Führen des zweiten Fluidstroms mit einer zwischen den einander zugewandten Oberflächen des ersten und zweiten Flachrohrs angeordneten Vielzahl von thermoelektrischen Pellets zeichnet sich dadurch aus, dass das erste und/oder zweite Flachrohr aus zumindest einem ersten und zweiten Teilsegment besteht, welche an ihrer Schnittstelle mittels eines Weichelementes zur Kompensation auftretender thermischer Spannungen fluidmäßig verbunden sind. Die Vorteile entsprechen denen des erfindungsgemäßen Flachrohrs.

Erfindungsgemäß ist die Wärmeübertragereinheit so ausgebildet, dass das erste und zweite Flachrohr an ihren jeweiligen Enden in unterschiedliche Sammelkästen münden. Dadurch erfolgt eine Aufteilung in Warm- und Kaltseite an den Endseiten der Wärmeübertragereinheit. Insbesondere sind an beiden Endbereichen der Flachrohre zwei nebeneinanderliegende Sammelkästen vorgesehen, wobei vorteilhaft die Verbindung der Endbereiche der Flachrohre mit den Sammelkästen über ein Verbindungselement verfügt, das eine Umlenkung des Fluidstromes zum Sammelkasten ermöglicht.

Zweckmäßigerweise umfasst ein thermoelektrisches Wärmeübertragermodul eine Vielzahl von thermoelektrischen Wärmeübertragereinheiten.

Weitere Vorteile, Merkmale und Einzelheiten der Erfindung ergeben sich aus der nachfolgenden Beschreibung, in der die Erfindung unter Bezug auf die Zeichnungen anhand von Ausführungsbeispielen Im Einzelnen beschrieben ist. Gleiche, ähnliche und/oder funktionsgleiche Teile können mit gleichen Bezugszeichen versehen sein.

Es zeigt, jeweils in schematischer Darstellung
- Fig.1: ein thermoelektrisches Element gemäß Stand der Technik,
- Fig. 1A: ein thermoelektrisches Element mit im Betriebsfall daran auftretenden Schubspannungen,
- Fig. 1B: den Aufbau eines Hochleistungs-Wärmeübertragers mit integriertem thermoelektrischen Element,
- Fig. 2: ein segmentiertes Flachrohr,
- Fig. 3: ein Flachrohrelement mit einer Isolatorschicht,
- Fig. 4A: ein oberes Flachrohrelement,
- Fig. 4B: ein unteres Flachrohrelement,
- Fig. 5: ein Flachrohrelement mit Isolatorschicht, Shunts und thermoelektrischem Halbleitermaterial,
- Fig. 6A: einen Schichtaufbau mit Flachrohrelementen,
- Fig. 6B: einen weiteren Schichtaufbau mit Flachrohrelementen.
- Fig. 7: einen weiteren Schichtaufbau mit Flachrohrelementen und entsprechenden Kontaktierungen,
- Fig. 8: Wärmeübertrager mit Sammelkästen,
- Fig. 9A: Wärmeübertrager mit Sammelkästen und Rundrohranschlüssen,
- Fig. 9B: Wärmeübertrager nach Fig. 9A in einer Draufsicht und
- Fig. 9C: eine Detaildarstellung eines Sammelkastens eines Wärmeübertragers gemäß Fig. 9A

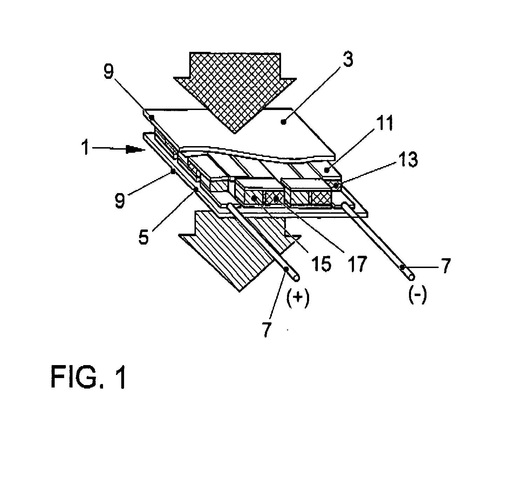

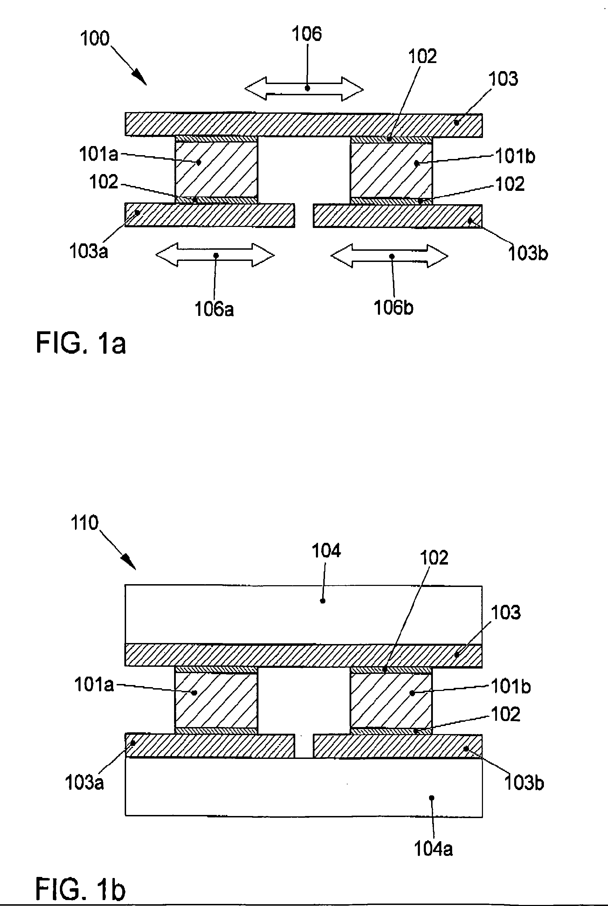

Fig. 1 zeigt ein thermoelektrisches Modul gemäß Stand der Technik. Das Modul 1 weist eine Kaltseite 3 und eine Warmseite 5 auf. Zum Anschließen an eine nicht näher dargestellte Gleichspannungsquelle weist das Modul 1 einen elektrischen Anschluss 7 auf. Bei einer angelegten Gleichspannung wirkt die Kaltseite 3 als Wärmesenke und die Warmseite 5 als Wärmequelle, wobei eine Umkehr der angelegten Spannung bewirkt, dass die Kaltseite 3 zur Wärmequelle und die Warmseite 5 zur Wärmesenke wird. Ferner kann das Modul 1 als thermoelektrischer Generator betrieben und/oder ausgelegt sein, wobei ein Anlegen einer Temperaturdifferenz zwischen der Kaltseite 3 und der Warmseite 5 eine Spannung an dem elektrischen Anschluss 7 induziert.

Die Kaltseite 3 und die Warmseite 5 weisen jeweils eine Isolationsschicht auf, beispielsweise ein keramisches Substrat. Zwischen den Isolationsschichten 9 sind eine Vielzahl von elektrischen Kontakten (Shunts) 11 angeordnet, die als rechteckförmige Plättchen ausgebildet sein können, beispielsweise als Metallplättchen, insbesondere als Kupferplättchen. Die Shunts 11 kontaktieren jeweils ein Paar aus zwei thermoelektrischen Materialien (Halbleitern) 13 bestehende Pellets, beispielsweise ein p-Halbleiter 15 und ein n-Halbleiter 17. Die Halbleiter 14, 17 sind mittels den Shunts 11 in Bezug auf die physikalische Stromflussrichtung so verschaltet, dass auf der Kaltseite 3 stets ein Übergang von dem p-Halbleiter 15 über den Shunt 11 auf den n-Halbleiter 17 erfolgt und auf der Warmseite umgekehrt stets ein Übergang von dem n-Halbleiter 17 auf den p-Halbleiter 15. Zwischen den Halbleitern 15, 17 verbleibt ein elektrisch isolierender Luftraum.

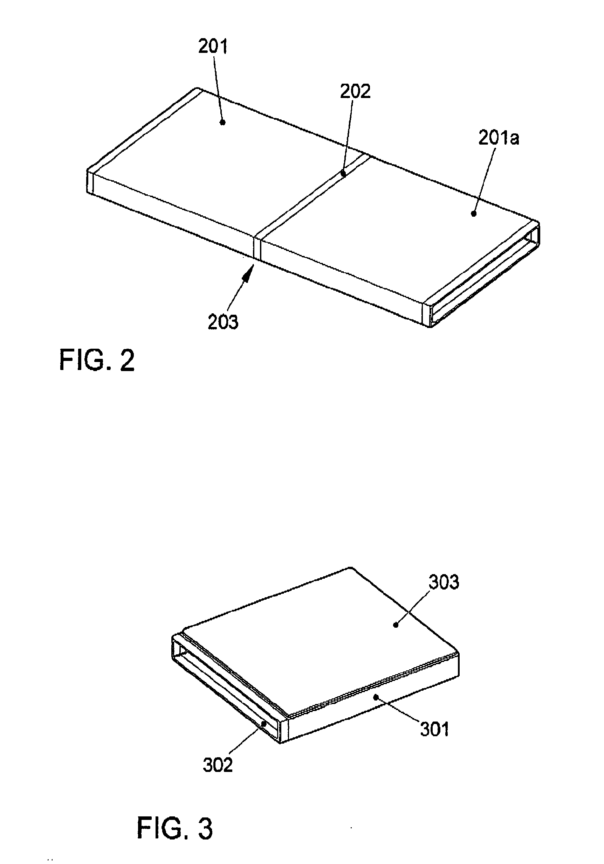

Fig. 1A zeigt für ein thermoelektrisches Element 100 mit Pellets (Komponenten) 101a, 101b aus einem Halbleitermaterial. Die Pellets 101 a, 101 b sind beispielsweise aus einem p-Halbleitermaterial beziehungsweise einem n-Halbleitermaterial und über einen Shunt 103 verbunden, wobei eine zwischen den Pellets 101a, 101b angeordnete Verbindungsschicht 102, insbesondere eine Lotschicht, eingesetzt wird. Die Pellets 101a, 101b sind ferner mit einem gegenüberliegenden Shunt 103a bzw. 103b, ebenfalls über eine Verbindungsschicht 102 verbunden. Zur Vereinfachung sind, wie auch in den Fig. 2 bis 6, keine elektrischen Anschlüsse dargestellt.

Im Betriebsfall kommt es zu einer Ausdehnung der Warmseite und zu einem Zusammenziehen der Kaltseite der Shunts 103, 103a, 103b, was zur Ausbildung von Schubspannungen zwischen den Shunts 103, 103a, 103b und den Pellets 101 a, 101 b führt; in Fig. 1A durch Pfeile 106, 106a, 106b angedeutet.

Fig. 1B zeigt einen thermoelektrischen Wärmetauscher 110 mit einem thermoelektrischen Element wie in Fig. 1A dargestellt, wobei auf den den Pellets 101a, 101 b entgegengesetzten Seiten der Shunts 103 bzw. 103a, 103b fluidführende Flachrohre 104 bzw. 104a angeordnet sind. Es versteht sich, dass im Betriebsfall einer derartigen thermoelektrischen Wärmeübertragers, wie in Fig. 1A gezeigt, Schubspannungen auftreten, die zu thermomechanischen Belastungen im Bereich der Verbindungsschichten 102 sowie im Grenzbereich zwischen den Wandungen der Flachrohre und den Shunts führen.

Erfindungsgemäß ist vorgesehen, wie in Figur 2 illustriert, ein Flachrohr einer thermoelektrischen Wärmepumpe aus zumindest zwei Teilsegmenten 201, 201 a zu bilden, wobei die Teilsegmente 201, 201 a an ihren Schnittstellen 203 mittels eines Weichelements 202 zur Kompensation von im Betrieb auftretenden thermischen Spannungen miteinander verbunden sind.

In Fig. 3 ist eine Ausführungsform eines Flachrohrelements eines erfindungsgemäßen Flachrohrs dargestellt, bei dem auf einer Oberseite des Elements eine Isolationsschicht 303 aufgebracht ist. Die Isolationsschicht ist vorzugsweise aus einem Material mit ausreichend guten elektrischen Isolationseigenschaften bei gleichzeitig hoher Wärmeleitfähigkeit gefertigt, beispielsweise aus einem Material, das Aluminiumnitrid umfasst. An einer Stirnseite des Flachrohrelements 301 ist in Fig. 3 ein Weichelement 302 zu erkennen. Eine Isolationsschicht, wie in Fig. 3 dargestellt, ist insbesondere auf aus leitfähigen Materialien gefertigten Flachrohren vorteilhaft, um einen elektrischen Kurzschluss der Hälbleitermaterial-Pellets über den Kontakt zwischen den Shunts und den Flachrohren zu verhindern.

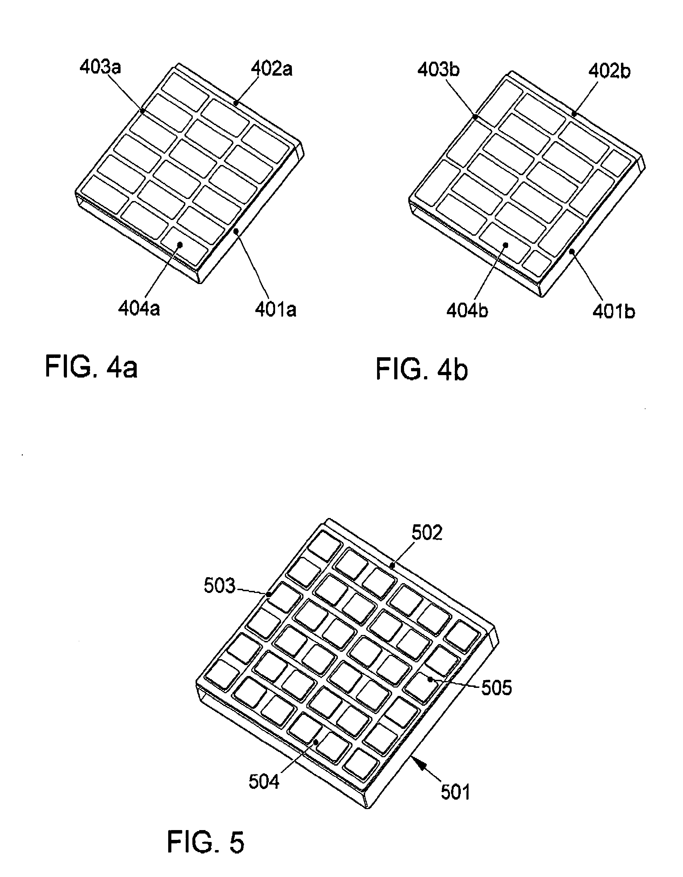

In den Fig. 4A und 4B sind auf einer Isolationsschicht 403a bzw. 403b eines Flachrohrelements 401 a bzw. 401 b aufgebrachte Shunts 404a bzw. 404b dargestellt. Dabei zeigt Fig. 4A ein oberes Flachrohrelement und Fig. 4B ein unteres Flachrohrelement. Die Bezeichnung "oberes" bzw. "unteres" Flachrohrelement ist dabei rein konventionell und dient zur Charakterisierung der räumlichen Anordnung der Vielzahl von ersten bzw. der Vielzahl von zweiten Shunts, mit der gewährleistet ist, dass die Pellets elektrisch in Reihe geschaltet sind. Aufgrund ihrer Anordnung auf der Oberfläche der isolationsschicht 403a bzw. 403b sind die Shunts und ebenso die auf ihnen angeordneten Pellets thermisch parallel geschaltet, so dass eine definierte Warm- und Kaltseite vorliegt. Es versteht sich, dass eine zu den Fig. 4A und 4B analoge Anordnung von Shunts direkt auf der Oberseite bzw. Unterseite von Flachrohren aus nichtleitendem Material, also ohne zwischen den Shunts und der Wandung der Flachrohre angeordnete Isolationsschicht ebenfalls von der Erfindung umfasst ist.

Vorzugsweise werden die Shunts mittels chemischer Gasphasenabscheidung (CVD) oder physikalischer Gasphasenabscheidung (PVD) auf das bereits mit der Isolationsschicht versehene Flachrohr aufgebracht. Falls auf die Isolationsschicht verzichtet werden kann, erfolgt die Aufbringung der Shunts unmittelbar auf das Flachrohr.

Die Anordnung der Vielzahl von ersten Shunts und der Vielzahl von zweiten Shunts, so dass die Pellets im Betrieb elektrisch in Reihe geschaltet sind, ist an sich aus dem Stand der Technik bereits bekannt, und beispielsweise auch in Fig. 1 illustriert.

In Fig. 5 ist ein unteres Flachrohrelement, wie in Fig. 4B dargestellt, veranschaulicht, wie eine Vielzahl von Pellets 505 auf eine Vielzahl von Shunts 504 aufgebracht sind, wobei die Shunts wiederum auf einer Isolationsschicht 503 aufgebracht sind. Die Pellets 505 sind dabei mittels eines thermischen Fügeprozesses, z.B. Weichlöten, mit den aufgebrachten Shunts 504, verbunden. Es versteht sich, dass alternativ oder zusätzlich auch eine Verbindung der Pellets mit den Shunts mittels einer Klebeschicht möglich ist.

Die Vielzahl von Pellets 505, wie in Fig. 5 dargestellt, kann nun mit einem Gegenstück, insbesondere einem in Fig. 4A dargestellten oberen Flachrohrelement im Bereich der Vielzahl von Shunts gefügt werden. Als Fügeprozess kommen hier wieder insbesondere Weichlöten oder Kleben in Frage.

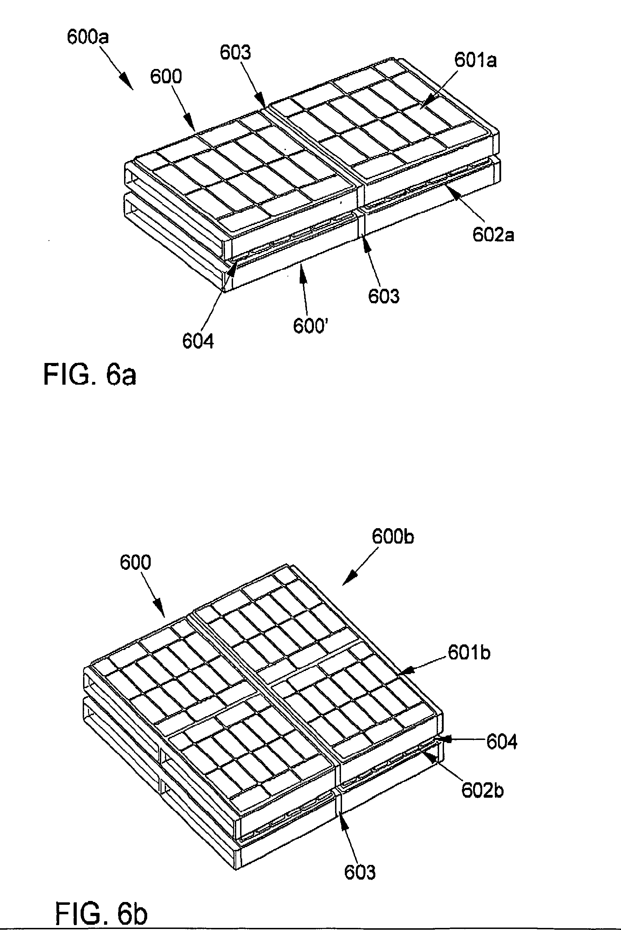

Eine thermoelektrische Wärmeübertragereinheit zum Übertragen eines Wärmestroms zwischen einem ersten und zweiten Fluidstrom mit einem ersten Flachrohr zum Führen des ersten Fluidstroms und einem zweiten Flachrohr zum Führen des zweiten Fluidstroms mit einer zwischen einander zugewandten Oberflächen des ersten und zweiten Flachrohrs angeordneten Vielzahl von thermoelektrischen Pellets kann dadurch gebildet sein, dass ein erstes und ein zweites Flachrohr aus zumindest einem ersten und zweiten Teilsegment besteht, die durch ein Weichelement verbunden sind. In Figur 6A ist veranschaulicht, wie damit ein Schichtaufbau 600a bestehend aus segmentierten Flachrohren 600, 600' realisiert werden kann, wobei eine erste Grundelementschicht 601a auf einer zweiten Grundelementschicht 602a mit dazwischen angebrachten Pellets 604 angeordnet ist, wobei die Teilsegmente jeweils durch ein Weichelement 603 verbunden sind. Analog ist in Fig. 6B ein weiterer Schichtaufbau 600b dargestellt, mit einer ersten Grundelementschicht 601 b auf einer zweiten Grundelementschicht 602b und dazwischen angeordneten Pellets 604, wobei Teilsegmente jeweils durch ein Weichelement 603 verbunden sind.

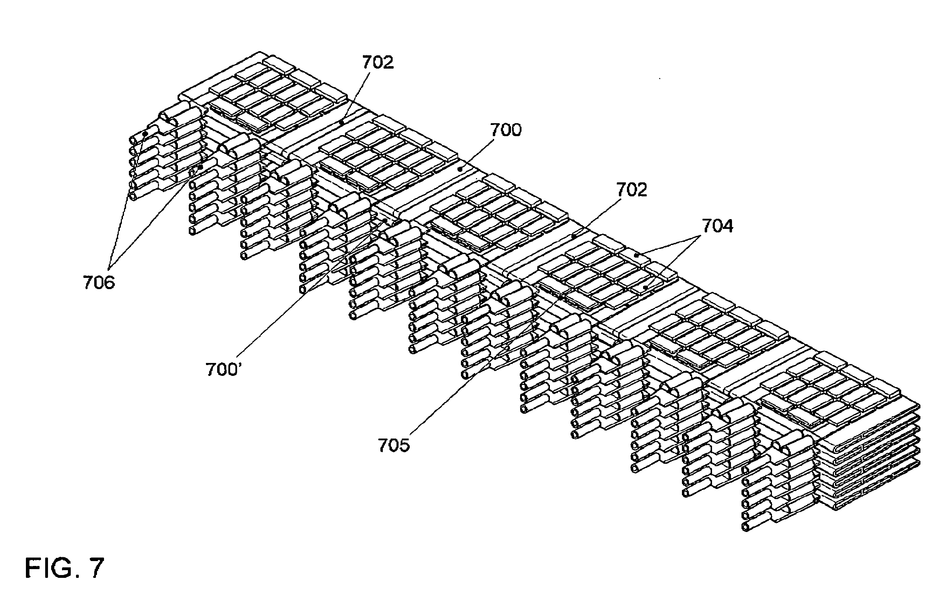

In ähnlicher Weise zeigt Fig. 7 den Aufbau einer Wärmeübertragereinheit zum Übertragen eines Wärmestroms zwischen einem ersten und zweiten Fluidstrom, wobei die übereinandergestapelten Flachrohre eine Vielzahl von segmentierten Flachrohren 700, 700' aufweisen, die wiederum jeweils über Weichelemente 702 verbunden sind. Zusätzlich ist aus dieser Darstellung die Kontaktierung der Shunts bzw. in mittelbarer Weise der p- oder n-Pellets über Kabelschuhe 706 gezeigt.

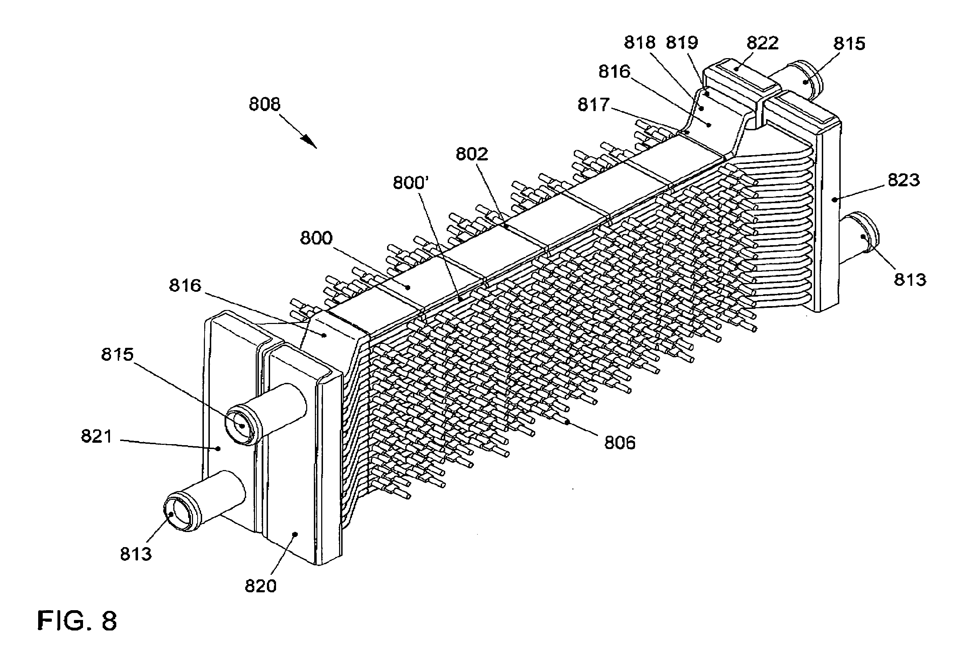

Eine Wärmeübertragereinheit 808 ist in Fig. 8 mit zusätzlichen Sammelkästen 814 zum Sammeln und Weiterbefördern der unterschiedlich temperierten Fluidströme dargestellt. Der Aufbau entspricht in seinem inneren Bereich im Wesentlichen der gemäß Fig.7 beschriebenen Ausführungsform, wobei jeweils sechs segmentierte Flachrohre 800 und 800' in Längsrichtung hintereinander in einem mittigen Block angeordnet und über Weichelemente 802 verbunden sind. An den jeweiligen Endbereichen dieses mittigen Blocks aus geradlinig ausgeführten Flachrohrsegmenten 800, 800' ist fluiddicht jeweils ein Verbindungselement 816 vorgesehen. Die Verbindungselemente 816 weisen ein geradliniges Ansatzstück 817 auf, welches mit dem Endbereich eines Flachrohres 800, 800' verbunden ist. Die Verbindung kann beispielsweise als Lötverbindung oder ebenfalls mittels eines Welchelements 802 ausgeführt sein. An das geradlinig geformte Ansatzstück 817 schließt abgewinkelt um 45° ein Winkelstück 818 an, welches wiederum an seinem Ende in ein geradliniges Ansatzstück 819 übergeht, welches in eine schlitzförmige Aufnahme eines Sammelkastens 820, 821, 822, 823 eingesteckt ist. Zur fluiddichten Verbindung ist auch zwischen dem Ansatzstück 819 und dem Sammelkasten eine Lötverbindung vorgesehen.

An den Enden der Wärmeübertragereinheit 8 sind jeweils zwei rechteckförmige Sammelkästen 820, 821 an der Fluideintrittsseite und zwei Sammelkästen 822, 823 an der Fluidaustrittsseite nebeneinander angeordnet, wobei jeweils einer der Sammelkästen 821, 823 mit einer Kaltseite 813 und die jeweils anderen 820, 822 mit einer Warmseite 815 der Fluidströme verbunden sind. Die segmentierten Flachrohre sind dabei so übereinander gestapelt, dass jeweils abwechselnd eine Lage der Flachrohre die Warmseite 815 und die darauffolgende Lage die Kaltseite 813 an den Sammelkästen verbindet. Betrachtet man die in Fig.8 dargestellte Anordnung, so führt das erste Ansatzstück 819 der obersten Lage an Flachrohren geradlinig unter einem Winkel von etwa 90° zur rückseitigen Fläche des rechten Sammelkastens 820 auf der Warmseite 815 Fluid zur weiteren Erwärmung in die weiteren Flachrohrsegmente 800. Dabei knickt der Strömungspfad im Winkelstück 818 des Verbindungselements 816 um etwa 45° nach innen. Anschließend durchläuft das Fluid die Flachrohrsegmente 800 und wird dabei thermoelektrisch erwärmt. Am Ende des Flachrohres schließt sich wiederum ein geradlinig geformtes Ansatzstück 817 an und der Strömungspfad ändert seine Richtung über das Verbindungselement 816 abermals um 45° und mündet anschließend in den linken austrittsseitigen Sammelkasten 822 der Warmseite. Das Fluid wird in diesem Pfad auf seinem Weg thermoelektrisch erwärmt, so dass es in weiterer Folge zu Heizzwecken Verwendung finden kann. Die Verbindungselemente 816 einer Flachrohrlage sind ein- und austrittsseitig im vorliegenden Ausführungsbeispiel im Wesentlichen parallel zueinander angeordnet.

Die darunterliegende Lage an Flachrohrsegmenten verbindet auf analoge Weise den eintrittseitigen Sammelkasten 821 der Kaltseite mit dem austrittseitigen Sammelkasten 823 der Kaltseite, wobei die Abwinkelung im Verbindungselement 816 genau entgegengesetzt zum jeweils darüberliegenden Flachrohr erfolgt. Das Fluid wird in diesem Pfad auf seinem Weg thermoelektrisch gekühlt.

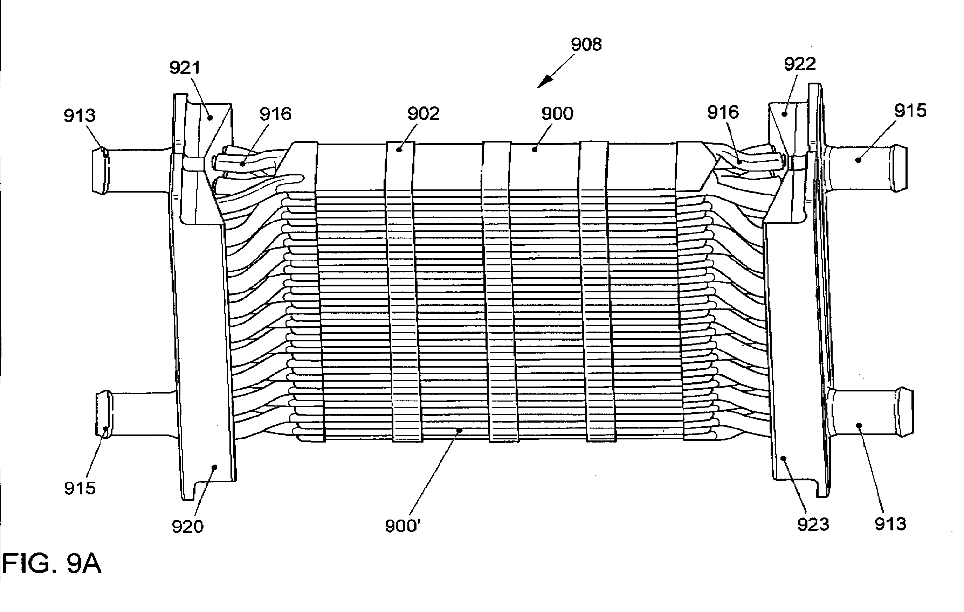

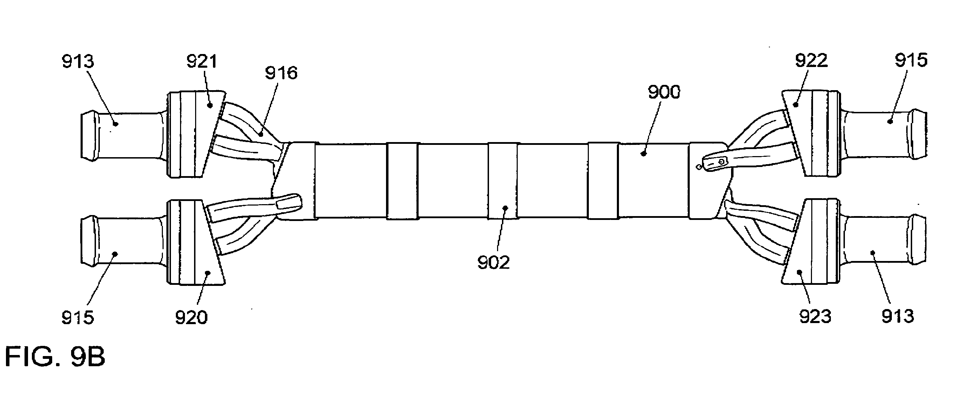

Eine weitere Ausführungsform für eine Wärmeübertragereinheit 908 ist in Fig. 9A dargestellt. Der Mittelblock besteht wiederum aus segmentierten Flachrohren 900, 900', die über Weichelemente 902 verbunden sind. In Unterscheidung zum vorhergehenden Ausführungsbeispiel sind die Verbindungselemente 916 so ausgeführt, dass diese an einem Ende die Geometrie der Flachrohrsegmente 900, 900' aufweisen und am anderen Ende jeweils zwei Rundrohre zum Anschluss an dafür vorgesehene Stutzen der Sammelkästen 920, 921, 922,923. Dies wird in einer Draufsicht nach Fig. 9B auf die Wärmeübertragereinheit 908 verdeutlicht. Die Verbindungselemente 916 zwischen den Sammelkästen 920, 921, 922, 923 und den Flachrohrsegmenten 900, 900' weisen jeweils einen Flachrohransatz auf, der in zwei abgewinkelt zur Längsebene des Wärmeübertragers bzw. der Flachrohrsegmente verlaufende Rundrohrstücke mündet. Die Enden der Rundrohrstücke treffen im Wesentlichen senkrecht auf eine zugewandte Anschluss- bzw. Abschlusswand 914 des jeweiligen Sammelkastens 920, 921, 922, 923. Zur Verbindung sind an der Anschlusswand entsprechende Rohrstutzen vorgesehen. Die Anschlusswand selbst ist etwa unter einem Winkel von 10° bis 30° zur Längsebene der Wärmeübertragereinheit geneigt.

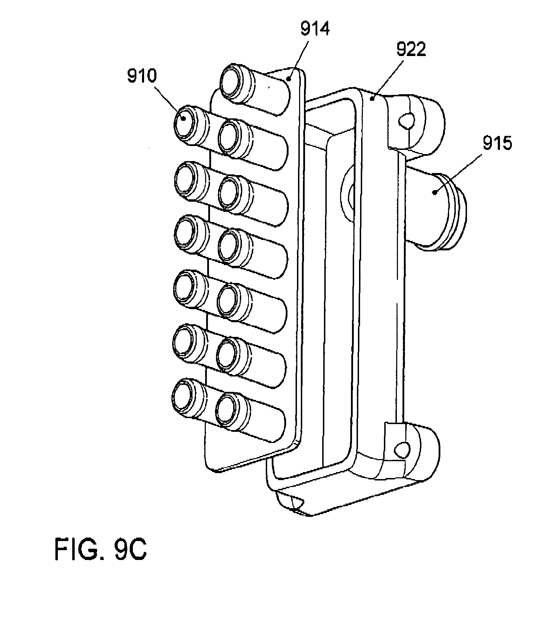

Eine Detaildarstellung eines solchen Sammelkastens 922 in Explosionsdarstellung zeigt Fig. 9C. Die geneigt angeordnete Anschlusswand 914 ist mit zwei parallel versetzten Reihen von Rohrstutzen 910 versehen, die zur Verbindung mit den Rohrendstücken der Verbindungselemente 916 vorgesehen sind. Durch die nebeneinander angeordneten Sammelkästen erfolgt sowohl eingangs- als auch ausgangseitig eine gute thermische Trennung der Strömungsfluide. Es versteht sich, dass die exemplarisch dargestellte Wärmeübertragereinheit nicht auf die vorliegende Anzahl von Flachrohren oder Verbindungsstücken beschränkt ist. Ja nach vorhandenem Verbauort und Anwendungsgebiet sind Variationen in der Länge der Flachrohrsegmente oder der dazu senkrechten Stapelung, insbesondere der Anzahl der Flachrohre denkbar.

### Bezugszeichenliste

- 1: thermoelektrisches Element
- 3, 813, 913: Kaltseite
- 5, 815, 915: Warmseite
- 808, 908: Wärmeübertragereinheit
- 7: elektrischer Anschluss
- 9: Isolierung
- 11: elektrische Kontakte
- 13: Halbleitermaterial
- 15: p-Halbleiter
- 17: n-Halbleiter
- 100a, 100b: Element
- 101a, 101b: thermoelektrisches Pellet
- 102: Verbindungsschicht
- 103, 103a, 103b: Shunt
- 104, 104a: Flachrohr
- 106, 106a, 106b: Schubspannungen
- 110: Wärmetauscher
- 201, 201a: Flachrohrsegment
- 202: Weichelement
- 203: Schnittstelle
- 301: Teilsegment
- 302: Weichelement
- 303: Isolatorschicht
- 401a, 401a: Flachrohrelement, Teilsegment
- 402a, 402b: Weichelement
- 403a, 403b: Isolatorschicht
- 404a, 404b: Shunts
- 501: Flachrohrelement, Teilsegment
- 502, 702, 802, 902: Weichelement
- 503: Isolatorschicht
- 504, 704: Shunts
- 505: Pellets
- 600, 600', 700, 700', 800, 800', 900, 900': Segmentiertes Flachrohr
- 600a, 600b: Schichtaufbau
- 601a, 601b: Grundelementschicht
- 602a, 602b: Grundelementschicht
- 603: Weichelement
- 604: Pellets
- 706, 806: Kabelschuh
- 820, 821, 822, 823, 920, 921, 922, 923: Sammelkasten
- 816, 916: Verbindungselement
- 817, 819: Ansatzstück
- 910: Stutzen
- 914: Anschlusswand

## Patentansprüche

1. Fluidführendes Flachrohr einer thermoelektrischen Wärmepumpe, das über eine Vielzahl von auf seiner Ober- und/oder Unterseite angeordneten ersten Shunts (103) verfügt, die eine Vielzahl von thermoelektrischen Pellets (101 a, 101 b) thermisch und elektrisch miteinander verbinden, wobei die thermoelektrischen Pellets (101 a, 101 b) auf der gegenüberliegenden Seite mit einer Vielzahl von zweiten Shunts (103a, 103b) thermisch und elektrisch verbunden sind und das Flachrohr aus zumindest einem ersten und einem zweiten Teilsegment (201, 201 a) besteht, welche an ihrer Schnittstelle (203) mittels zumindest eines Weichelementes (202) zur Kompensation auftretender thermischer Spannungen miteinander verbunden sind, **dadurch gekennzeichnet, dass** die Vielzahl von ersten Shunts und die Vielzahl von zweiten Shunts derartig angeordnet sind, dass die thermoelektrischen Pellets elektrisch in Reihe geschaltet sind oder schaltbar sind.

2. Flachrohr nach Anspruch 1, **dadurch gekennzeichnet, dass** zumindest eines der Teilsegmente (401 a, 401 b) auf seiner Ober- und/oder Unterseite eine wärmeleitende Isolationsschicht (403a, 403b) aufweist, auf der die Vielzahl der ersten Shunts (404a, 404b) angebracht sind.

3. Flachrohr nach Anspruch 1 oder 2, **dadurch gekennzeichnet, dass** die Vielzahl von ersten Shunts (103) und/oder die Vielzahl von zweiten Shunts (103a, 103b) thermisch und elektrisch mittels einer Lotverbindung mit den thermoelektrischen Pellets (101 a, 101b) verbunden sind.

4. Flachrohr nach einem der Ansprüche 1 bis 3, **dadurch gekennzeichnet, dass** die Vielzahl von ersten Shunts (103) und/oder die Vielzahl von zweiten Shunts (103a, 103b) thermisch und elektrisch mittels einer Klebeverbindung mit den thermoelektrischen Pellets (101 a, 101 b) verbunden sind.

5. Flachrohr nach einem der vorhergehenden Ansprüche, **dadurch gekennzeichnet, dass** das (302) Weichelement lippenartig ausgebildet und an einer ersten Stirnfläche eines ersten Flachrohrelements (301) und an einer zweiten Stirnfläche eines zweiten Flachrohrelements angeordnet ist, wobei die Flachrohrelemente die Teilsegmente des Flachrohrs bilden.

6. Flachrohr nach einem der vorhergehenden Ansprüche, **dadurch gekennzeichnet, dass** das Weichelement (302) aus einem Elastomermaterial oder einem thermoplastischen Elastomermaterial besteht

7. Thermoelektrische Wärmeübertragereinheit zum Übertragen eines Wärmestroms zwischen einem ersten und zweiten Fluidstrom mit einem ersten Flachrohr (104) zum Führen des ersten Fluidstroms und einem zweiten Flachrohr (104a) zum Führen des zweiten Fluidstroms mit einer zwischen einander zugewandten Oberflächen des ersten und zweiten Flachrohrs angeordneten Vielzahl von thermoelektrischen Pellets (101a, 101b)und das erste und/oder zweite Flachrohr (104, 104a) aus zumindest einem ersten und zweiten Teilsegment (201, 201 a) besteht, welche an ihrer Schnittstelle (203) mittels eines Weichelementes (202) zur Kompensation auftretender thermischer Spannungen miteinander verbunden sind, **dadurch gekennzeichnet, dass** das erste (800, 900) und zweite Flachrohr (800', 900') an Ihren jeweiligen Enden in unterschiedlichen Sammelkästen (820, 821, 822, 823, 920, 921, 922, 923) münden.

8. Wärmeübertragereinheit nach Anspruch 7, **dadurch gekennzeichnet, dass** an beiden Endbereichen der Flachrohre zwei nebeneinanderliegende Sammelkästen (822, 823; 820, 821; 922, 923; 921, 920) vorgesehen sind.

9. Wärmeübertragereinheit nach einem der Ansprüche 7 bis 8, **dadurch gekennzeichnet, dass** die Verbindung der Endbereiche der Flachrohre mit den Sammelkästen über ein Verbindungselement (816, 916) vorgesehen ist, das eine Umlenkung des Fluidstromes zu den jeweiligen Sammelkasten ermöglicht.

10. Thermoelektrisches Wärmeübertragermodul mit einer Vielzahl von thermoelektrischen Wärmeübertragereinheiten nach einem der Ansprüche 7 bis 9.

## Claims

1. Fluid-carrying flat tube of a thermoelectric heat pump, which flat tube has a large number of first shunts (103) which are arranged on its top face and/or bottom face and which thermally and electrically connect a large number of thermoelectric pellets (101a, 101b) to one another, wherein the thermoelectric pellets (101a, 101b) are thermally and electrically connected to a large number of second shunts (103a, 103b) on the opposite side, and the flat tube comprises at least one first and one second subsegment (201, 201a) which are connected to one another at their interface (203) by means of at least one flexible element (202) for compensating thermal stresses which occur, **characterized in that** the large number of first shunts and the large number of second shunts are arranged in such a way that the thermoelectric pellets are connected or can be connected electrically in series.

2. Flat tube according to Claim 1, **characterized in that** at least one of the subsegments (401a, 401b) has a thermally conductive insulation layer (403a, 403b) on its top and/or bottom face, the large number of first shunts (404a, 404b) being mounted on the said insulation layer.

3. Flat tube according to Claim 1 or 2, **characterized in that** the large number of first shunts (103) and/or the large number of second shunts (103a, 103b) are thermally and electrically connected to the thermoelectric pellets (101a, 101b) by means of a solder connection.

4. Flat tube according to one of Claims 1 to 3, **characterized in that** the large number of first shunts (103) and/or the large number of second shunts (103a, 103b) are thermally and electrically connected to the thermoelectric pellets (101a, 101b) by means of an adhesive-bonding connection.

5. Flat tube according to one of the preceding claims, **characterized in that** the flexible element (302) is designed in the manner of a lip and is arranged on a first end face of a first flat tube element (301) and on a second end face of a second flat tube element, wherein the flat tube elements form the subsegments of the flat tube.

6. Flat tube according to one of the preceding claims, **characterized in that** the flexible element (302) is composed of an elastomeric material or a thermoplastic elastomeric material.

7. Thermoelectric heat transfer unit for transferring a heat flow between a first and second fluid flow, comprising a first flat tube (104) for carrying the first fluid flow and comprising a second flat tube (104a) for carrying the second fluid flow having a large number of thermoelectric pellets (101a, 101b), which are arranged between facing surfaces of the first and second flat tubes, and the first and/or second flat tube (104, 104a) comprises at least a first and second subsegment (201, 201a) which are connected to one another at their interface (203) by means of a flexible element (202) for compensating thermal stresses which occur, **characterized in that** the first flat tube (800, 900) and the second flat tube (800', 900') issue at their respective ends in different header boxes (820, 821, 822, 823, 920, 921, 922, 923).

8. Heat transfer unit according to Claim 7, **characterized in that** two header boxes (822, 823; 820, 821; 922, 923; 921, 920) which are situated next to one another are provided at the two end regions of the flat tubes.

9. Heat transfer unit according to either of Claims 7 and 8, **characterized in that** the connection of the end regions of the flat tubes to the header boxes is provided by means of a connecting element (816, 916) which allows the fluid flow to be deflected to the respective header box.

10. Thermoelectric heat transfer module having a large number of thermoelectric heat transfer units according to one of Claims 7 to 9.

## Revendications

1. Tube plat véhiculant du fluide d'une pompe à chaleur thermoélectrique, lequel dispose d'une pluralité de premiers shunts (103) disposés sur son côté supérieur et/ou inférieur, lesquels relient ensemble de manière thermique et électrique une pluralité de granulés thermoélectriques (101a, 101b), dans lequel les granulés thermoélectriques (101a, 101b) sont reliés thermiquement et électriquement sur le côté situé en vis-à-vis à une pluralité de seconds shunts (103a, 103b) et le tube plat se composant au moins d'un premier et d'un second segment partiel (201, 201a), lesquels sont reliés l'un à l'autre au niveau de leur interface (203) au moyen d'au moins un élément tendre (202) pour la compensation de contraintes thermiques apparaissant, **caractérisé en ce que** la pluralité des premiers shunts et la pluralité des seconds shunts sont disposés de manière à ce que les granulés thermoélectriques soient connectés électriquement en série ou soient connectables électriquement en série.

2. Tube plat selon la revendication 1, **caractérisé en ce qu'**au moins l'un des segments partiels (401a, 401b) présente sur son côté supérieur et/ou inférieur une couche d'isolation thermoconductrice (403a, 403b) sur laquelle la pluralité des premiers shunts (404a, 404b) sont placés.

3. Tube plat selon la revendication 1 ou 2, **caractérisé en ce que** la pluralité des premiers shunts (103) et/ou la pluralité des seconds shunts (103a, 103b) sont reliés thermiquement et électriquement, au moyen d'une liaison soudée, aux granulés thermoélectriques (101a, 101b).

4. Tube plat selon l'une des revendications 1 à 3, **caractérisé en ce que** la pluralité des premiers shunts (103) et/ou la pluralité des seconds shunts (103a, 103b) sont reliés thermiquement et électriquement, au moyen d'une liaison par collage, aux granulés thermoélectriques (101a, 101b).

5. Tube plat selon l'une des revendications précédentes, **caractérisé en ce que** l'élément tendre (302) est réalisé à la manière de lèvres et est disposé sur une première surface frontale d'un premier élément de tube plat (301) et sur une seconde surface frontale d'un second élément de tube plat, dans lequel les éléments de tube plat forment les segments partiels du tube plat.

6. Tube plat selon l'une des revendications précédentes, **caractérisé en ce que** l'élément tendre (302) se compose d'un matériau élastomère ou d'un matériau élastomère thermoplastique.

7. Unité thermoélectrique de transfert de chaleur pour le transfert d'un flux de chaleur entre un premier et un second flux de fluide avec un premier tube plat (104) pour la conduction du premier flux de fluide et un second tube plat (104a) pour la conduction du second flux de fluide avec une pluralité de granulés thermoélectriques (101a, 101b) disposés entre des surfaces, se faisant face, des premier et second tubes plats, et le premier et/ou second tube plat (104, 104a) se composant(s) au moins d'un premier et d'un second segment partiel (201, 201a), lesquels sont reliés ensemble au niveau de leur interface (203) au moyen d'un élément tendre (202) pour la compensation de contraintes thermiques apparaissant, **caractérisée en ce que** le premier (800, 900) et le second tube plat (800', 900') débouchent au niveau de leurs extrémités respectives dans des boîtes de collecte (820, 821, 822, 823, 920, 921, 922, 923) différentes.

8. Unité de transfert de chaleur selon la revendication 7, **caractérisée en ce que** l'on prévoit, aux deux extrémités des tubes plats, deux boîtes de collecte (822, 823 ; 820, 821 ; 922, 923 ; 921, 920) situées l'une à côté de l'autre.

9. Unité de transfert de chaleur selon l'une des revendications 7 à 8, **caractérisée en ce que** la liaison entre les zones d'extrémité des tubes plats et les boîtes de collecte est prévue grâce à un élément de liaison (816, 916), lequel permet une déviation du flux de fluide vers les boîtes de collecte respectives.

10. Module thermoélectrique de transfert de chaleur avec une pluralité d'unités thermoélectriques de transfert de chaleur selon l'une des revendications 7 à 9.
